# EUROPEAN PATENT APPLICATION

(11) **EP 4 790 399 A1**
(43) Date of publication of application: **12.08.2026**
(21) Application number: 25156205.4
(22) Date of filing: 06.02.2025
(51) Int. Cl.: G01N 24/08, G01R 33/30

(54) **CONTAINERIZED IMAGING SYSTEM FOR ANALYSING INDUSTRIAL SAMPLES**

(71) Applicant: Orbem GmbH, 80935 Munich (DE)
(72) Inventor: CECILIA MAHAVADI, Mira, Munich (DE); MOLINA ROMERO, Miguel, Munich (DE); KUDIELKA, Guido, Munich (DE); SHAPIRO, Simon Levi, Munich (DE)
(74) Representative: Pelster Behrends Patentanwälte PartG mbB

(57) **Abstract**

The invention relates to a containerized imaging system (10) for the analysis of samples (12), comprising: i) a container (14) with a container casing (16), wherein the container casing (16) comprises one or more apertures for introducing samples (12) into the container (14) and for removing samples (12) from the container (14), ii) an imaging scanner (22) for the analysis of samples (12), wherein the imaging scanner (22) is located inside the container (14), and iii) a sample handling system (24) for handling samples (12), wherein the sample handling system (24) is at least partially located inside the container (14).

## Description

### Technical field

The present invention relates to a containerized system, a modular containerized assembly comprising such a containerized system and a method for analysing samples with the respective containerized system. Also disclosed is an augmented facility comprising said containerized system or modular containerized assembly.

### Technical background

In modern industry, advanced automation technologies have resulted in higher production and productivity, wherein industrial processes have undergone considerable changes in the past decades. In recent years, various industries have significantly increased the overall output, i.e. the number of processed industrial products per hour, resulting in high-throughput, i.e. fast processing and reduced processing times for each individual industrial product. At the same time, customers' expectations regarding product quality and/or the extent of official regulations have increased, so that a consistent product quality must be accomplished despite the high productivity. Furthermore, several industries rely on the accurate assessment of the features and the quality of relevant base materials, e.g. the fertility status of an egg in the case of hatcheries or the expected productivity of seeds in the agriculture industry. Therefore, enabling accelerated analysis of industrial samples is highly relevant for various industrial fields, both for quality control and property prediction.

A promising approach to satisfy this demand and to allow for a high-throughput analysis of samples are MR (magnetic resonance) based techniques and in particular the use of Magnetic Resonance Imaging (MRI). The use of MRI techniques for providing information about e.g. the interior of industrial products has recently moved into the focus of development. Herein, several different concepts for analysing properties of industrial samples with imaging techniques are discussed in the prior art, e.g. in EP 3 483 619 A1, US 6,149,956 A, WO 02/059586 A2, US 10,338,015 B2, US 2019/011383 A1 and EP 4202427 A1.

Due to its fundamental relevance for the commercial potential of MR in industrial application, a lot of attention is so far only given to the optimization of the sample throughput, which is strongly influenced by the potential scan speed, the field of view that needs to be sampled and by the overall MR processing rate.

Despite the enormous potential offered by the use of MR based techniques in the high-throughput analysis of samples, less attention was given in the prior art to some of the more fundamental challenges of introducing MR based quality control or feature analysis into modern production lines.

Typically, most facilities do not have suitable MR equipment available that could be readily utilized for enabling MR based analysis in the production line. Furthermore, MR scanners comprise sophisticated equipment and typically require comprehensive infrastructure to be operational. Apart from this, the operation of MR systems usually requires comprehensive precaution measures due to the strong magnetic fields employed by many modern MR scanners and the low temperature liquids required to operate the super conducting electromagnetic coils.

Although the implementation of MR based techniques for augmenting existing industrial processes is highly desirable, it is often found that the challenges associated with the introduction of such techniques into existing processes is preventing a more widespread use, particularly if such techniques are required only seasonally. Likewise, the peculiarities and comprehensive requirements for safely operating the required MR equipment, particularly from a regulatory perspective, can prejudice the inclusion of such MR based techniques into newly designed production lines as well.

It was the primary objective of the present invention to overcome or at least reduce the disadvantages of the prior art.

In particular, it was the objective of the present invention to provide for a solution that facilitates the use of imaging, preferably MR based techniques for the high-throughput analysis of samples, while ensuring a save and compliant operation environment for the handling of the required sophisticated equipment.

It was an additional objective of the present invention to allow for efficiently and flexibly upgrading existing facilities and production processes by incorporating imaging, preferably MR based techniques for the high-throughput analysis of samples.

Furthermore, it was an objective of the present invention to provide for a solution that allows to include imaging, preferably MR based techniques for the high-throughput analysis of samples in a broad variety of existing and future processes while reducing the regulatory and operational requirements for the remaining parts of the processes or the facilities, respectively. In this respect, it was especially preferred that the solution should also allow for efficiently realizing specialized working conditions within the production process, e.g. by offering clean room or biosafety capabilities.

It was another objective of the present invention to provide for an efficient upscaling of the imaging, preferably MR capabilities and to allow for an easy expansion of the number of MR systems that are integrated into the production line. Insofar, it was desirable to offer the potential for quickly transferring the imaging, preferably MR capabilities from one facility to another, preferably even between facilities in different countries or on different continents.

In view of the above, it was an overarching objective of the present invention to provide for a more cost-effective and sustainable use of imaging, preferably MR based techniques for the high-throughput analysis of samples in several industries.

Building on this, it was an objective of the present invention to provide for an efficient method for analysing samples with imaging, preferably MR based techniques.

It was a further objective of the present invention to provide a beneficial augmented facility that exhibits powerful imaging, preferably MR capabilities for the imaging, preferably MR based high-throughput analysis of samples.

### Summary of the invention

A solution is provided according to the subject matter of the independent claims. Further preferred embodiments are set out in the dependent claims.

In particular, the inventors of the present invention have now found that the above-described objectives can surprisingly be achieved by providing a relocatable, containerized "plug-in" imaging, preferably MR system to allow for fully automated live sample analytics for a broad variety of industrial applications utilizing a remotely controlled imaging, preferably MR scanner. Beneficially, the containerized imaging system can easily be shipped and installed at existing facilities, wherein it can readily be extended with modular elements of other containerized imaging systems to increase the analysed volume of samples per hour. In an example, the containerized imaging system can be connected to an industrial facility (e.g. hatchery, factory), such that samples are transferred between the facility (through modified openings thereof) and the containerized MR system. In another example, the containerized imaging system can be installed (temporarily) inside such a facility and connected to the production line within the facility. For example, the samples to be analyzed can be introduced into the containerized imaging system, transported within the container, and removed from the container using an automation flow. In other words, the inherently relocatable containerized imaging system is making use of a transportable container ensuring a controlled industrial environment (e.g. for ensuring biosafety) and designed to allow for an easy connection to (existing) industrial automation lines. Correspondingly, the invention enables fully automated high-throughput live analytics of industrial samples by providing a pre-installed, easy-to-connect and relocatable "plug-in" module in the form of a containerized imaging system for industrial production settings.

Thus, the aforementioned objectives are solved by the subject-matter of the present invention as defined in the claims. Hereinafter, the subject-matter of the invention is discussed in more detail, wherein preferred embodiments of the invention are disclosed.

It is particularly preferred to combine two or more of the preferred embodiments to obtain an especially preferred embodiment. Correspondingly, especially preferred is a method according to the invention, that defines two or more features of preferred embodiments of the present invention. Also preferred are embodiments in which a feature of one embodiment that is to some extent designated as preferred is combined with one or more further features of other embodiments that are designated to some extent as preferred. Features of preferred modular containerized imaging, preferably MR assemblies, augmented facilities and methods result from features of preferred containerized imaging, preferably MR systems.

Particularly preferred embodiments of the invention are disclosed in the exemplary embodiments depicted in the figures. Correspondingly, particularly preferred embodiments of the invention combine two or more, preferably three or more, very preferably four or more, of the preferred features of the invention disclosed below, which are also implemented in the exemplary embodiments.

The present invention relates to a containerized imaging, preferably MR system for the analysis of samples, comprising:
i) a container with a container casing,
   wherein the container casing comprises one or more apertures for introducing samples into the container and for removing samples from the container,
ii) an imaging scanner, preferably a MR scanner for the analysis of samples (preferably using magnetic resonance techniques), wherein the imaging scanner is located inside the container, and
iii) a sample handling system for handling samples, wherein the sample handling system is at least partially located inside the container,

wherein the containerized imaging system is configured to move samples from one of the one or more apertures into the imaging scanner using the sample handling system,
wherein the containerized imaging system is configured to analyse samples, particularly the samples moved into the imaging scanner, using the imaging scanner, and
wherein the containerized imaging system is configured to move samples, particularly the analysed samples, from the imaging scanner to one of the one or more apertures using the sample handling system.

Preferably, the system is transportable, i.e. it can be transported as a whole without having to disassemble the imaging scanner and/or the sample handling system from the container. It may thus be possible to relocate the entire system by relocating the container which houses the imaging scanner and sample handling system. Accordingly, the imaging scanner and/or the sample handling system may be securable to the container providing for a secure transport of the overall system.

Preferably, the system is a stand-alone system, i.e. it may be a self-sufficient and independent system that can generally be operated without requiring connection or interaction with other systems. Accordingly, the system may comprise all functionality and/or control units necessary for operating the system for the analysis of samples. The person skilled in the art understands that, after connecting the system to a power source and possibly to a data source of an external facility, the system may readily be used to analyse samples.

In the concept of the present invention, the imaging scanner may be any suitable scanner in view of the sample to be analysed, including but not limited to an MR scanner, an X-ray scanner, a CT scanner, an ultrasound scanner, a Doppler scanner, or the like. Preferably, the analysis with the imaging scanner is performed in a non-invasive manner. Preferably, the imaging scanner is configured to use imaging techniques that at least partially depict the inside of the sample. Preferably, the imaging scanner has a weight of at least 10 kg, further preferred of at least 100 kg, further preferred of at least 200 kg, further preferred of at least 1000 kg. The containerized imaging system is particularly suitable to flexibly provide analysis techniques to a facility which can otherwise only be provided with large efforts due to the heavy load of the respective imaging scanner. In a particularly preferred embodiment, the imaging scanner is an MR scanner.

In the following, the concept of the present invention is described with reference to a containerized imaging system being a containerized MR system having an imaging scanner being an MR scanner. It will be appreciated that the configuration and functionality of the MR containerized MR system are not limited to that particular system, but similarly apply to the claimed general containerized imaging system having an imaging scanner different from an MR scanner.

The present invention particularly relates to a containerized MR system for the analysis of samples. In agreement with the skilled person's understanding the abbreviation MR stands for "magnetic resonance". The concept of "magnetic resonance", including "magnetic resonance imaging" (MRI), is well known to the skilled person in the relevant field and MR and MRI scanners that can be adapted for inclusion in the containerized MR systems of the present invention are commercially available from different suppliers.

The core of the present invention relates to the arrangement of specific components in a certain way. Thus, the fundamental concepts of MR and MRI as well as the underlying physical basics do not need to be discussed in detail for understanding the present invention. Correspondingly, with respect to the background of MR and MRI, reference can be made to the prior art, e.g. as cited above. Accordingly, the MR scanner of the containerized MR system may be any suitable MR (preferably MRI) scanner allowing for analyzing the sample in view of the respective implementation.

The containerized MR system of the present invention provides a "plug-in" functionality such that it can readily be integrated into existing facilities and production lines or can be used to enable high-throughput MR analytic capabilities in new facilities in a cost-effective way. In this regard, it is an important advantage of the containerized MR system of the present invention that it can readily be used to confer high-throughput MR analytic capabilities to basically any type of facility that is in need for enhanced sample analysis.

It can be envisioned that the high-throughput MR analytic capabilities enabled by the containerized MR system of the present invention can be used in various applications. For example, the containerized MR system can be used with facilities belonging -broadly speaking- to the medical field that could require high-throughput analysis of samples, e.g. blood banks, pathologies or medical laboratories. In a further example, the containerized MR system can be used with industrial facilities from other industries, e.g. agricultural industry, fishing industry, electronic industry or food industry. A containerized MR system according to the invention is particularly preferred for the vast majority of applications, wherein the samples are industrial samples. The term "industrial samples" as used herein may refer to samples coming from and/or being further processed in industrial facilities. In agreement with the understanding of the skilled person, the term "industrial samples" does not comprise alive humans (and preferably also not alive animals) - with life starting at birth.

Preferred is a containerized MR system according to the invention, wherein the industrial samples are selected from the group consisting of polymeric products, animal products, plants, and products derived from these materials. Preferably, the industrial samples include one or more of plastics, organic tissues, meat, fish meat, eggs, fruits, seeds, wood and processed food and drinks. Preferably the industrial samples include one or more of eggs, seeds, nuts, wood and chocolate products. Preferably, the industrial samples are selected from the group consisting of manufactured products, preferably energy storage devices, electronic devices and medical products. The skilled person understands that this list is not exhausting, and that further industrial samples may be analysed with the claimed containerized MR system.

Based on the assumption of the inventors most applications of the containerized MR systems of the present invention will include samples that are at least predominantly solid matter. However, it can be envisioned to utilize the containerized MR systems of the present invention for the analysis of fluids as well. The sample handling system is adapted to the respective state of the samples to be analysed. Thus, the containerized MR system according to the invention can be used to analyse samples that are liquid (e.g. at room temperature) or even gaseous.

An important part of the containerized MR system according to the invention is the container. The container may be transportable, i.e. it may be configured, dimensioned and structured such that it can readily be relocated without having to remove the imaging scanner and/or the sample handling system from the container. Using the container, the MR system is eventually containerized. In agreement with the skilled person's understanding, the container may have a container casing that at least partially surrounds the container's interior and provides some amount of protection against external influences. Preferably, the container casing comprises a container floor, a container ceiling, and one or more (detachable) container sidewalls. The container must not necessarily fully enclose the MR scanner located therein, as one or more sidewalls of the container casing may be removed when using the containerized MR system in MR assembly as described further below. The MR scanner is preferably fixed to the container floor.

The container is dimensioned and configured for hosting the MR scanner. Accordingly, the container may be made of or comprise a sufficiently rigid material such as steel. Further, the container casing may enclose a volume of at least 4 m³, preferably of at least 8 m³, more preferably of at least 12 m³, more preferably of at least 16 m³, more preferably of at least 33 m³, more preferably of at least 67 m³. Accordingly, the container may have a minimum volume sufficiently large for hosting the MR scanner. Preferably, the container's volume is sufficiently large to also host additional equipment.

While larger containers offer more freedom for housing larger MR scanners, one important benefit of the present invention lies in the possibility to easily move the containerized MR system. Therefore, it is expedient to somewhat limit the container size to ensure that it can be transported efficiently. Correspondingly, a containerized MR system according to the invention is preferred, wherein the container is reversibly and nondestructively movable, preferably using a crane or forklift. To facilitate this movability, a containerized MR system according to the invention is especially preferred, wherein the outside of the container casing comprises one or more carrying elements for connecting the container to a crane or forklift.

Overall, a containerized MR system according to the invention is especially preferred, wherein the container is adapted to be transportable by trucks, trains, ships or planes, preferably trucks. Preferably, the container can be stacked on top of (or beneath) other or similar containers.

In order to allow for an efficient adaptation of the containerized MR system to existing logistic chains, it is especially expedient to use standardized containers that are already used in international logistics. This brings the added benefit of being able to easily source such containers from a broad variety of suppliers when producing containerized MR systems that only need to be modified to fit the requirements of the present invention. For example, due to the weight of the containerized MR equipment, it might be required to structurally reinforce standardized shipping containers. In view of this, a containerized MR system according to the invention is preferred, wherein the container is based on a standardized shipping container or on a structurally reinforced shipping container. Preferably, the container is a standardized shipping container modified to include the aperture(s) and if necessary to support the MR scanner. The shipping container may be an intermodal container (also called ISO container), as for example defined in ISO 830:(1999), ISO 830:(2024), ISO 668, ISO 1496-1:2013, and/or ISO 1496-2:2018.

With respect to the choice of material for the container, beneficial results can be obtained by using metals, as the resulting containers are especially resilient, in particular against mechanical stress or environmental effects like harsh weather conditions. As the container houses a MR scanner that employs potentially strong magnetic fields, it is expedient to use metals that are non-magnetic, wherein not only stainless steel but also composite materials can be used, wherein the latter allows for tailoring the properties of the container precisely to the requirements of the respective application and typically allows for very light weight embodiments. Taking this into account, a containerized MR system according to the invention is preferred, wherein the container casing comprises or is at least partially, preferably predominantly, more preferably essentially completely, consisting of metal, preferably aluminium or steel, most preferably stainless steel, and/or wherein the container casing comprises or is at least partially, preferably predominantly, more preferably essentially completely, consisting of a non-magnetic material, preferably a non-magnetic metal or a non-metallic composite material, more preferably a non-magnetic metal. The container must not necessarily comprise any metal. The container may comprise, at least partially, a plastic material, which may allow for thermal management by controlling heat flows in line with requirements for operating the MR scanner.

An especially preferred use of the containerized MR system according to the invention is its use in a modular containerized MR assembly that comprises several such containerized MR systems that are interconnected as disclosed hereafter. In order to facilitate the modular interconnection of containerized MR systems, the container can be designed with one or more removable sidewall elements, thereby allowing to connect two containerized MR systems to form a larger interior. Thus, a containerized MR system according to the invention is preferred, wherein the container casing has one or more container sidewalls that are reversibly and non-destructively removably connected to a base structure of the container casing. The base structure may be defined by a frame, other sidewalls, the container floor, and/or the container ceiling. By removing one of the sidewalls, the basic structure of the container is not impaired.

According to the invention the container casing comprises one or more apertures for introducing samples into the container and for removing samples from the container. One of the one or more apertures may be an entry aperture for introducing samples into the container. The same aperture or another one of the one or more apertures may be an exit aperture for removing samples from the container. Accordingly, the entry aperture may be the (structurally and/or functionally) same as or different from the exit aperture. In other words, the entry aperture and the exit aperture may allow for routing a sample from a facility, to which the containerized MR system is connected to or where the containerized MR system is installed in, into the containerized MR system and back to the facility. The aperture(s) may thus be linked to respective openings of the facility to allow for the transfer of samples between the facility and the containerized MR system.

Generally, samples may be introduced to or removed from the containerized MR system via the container ceiling, the container floor, and/or the container sidewalls. Accordingly, one or more apertures may be provided in the container ceiling, the container floor, and/or the container sidewalls. In a preferred embodiment, the aperture(s), the entry aperture, and/or the exit aperture, preferably both the entry aperture and the exit aperture, are placed in a sidewall, preferably the same sidewall, of the container casing.

Preferably, the container casing comprises one aperture for introducing samples into the container and for removing samples from the container. In this embodiment, the containerized MR system is configured to move samples from the one aperture into the MR scanner using the sample handling system and to move samples from the MR scanner to the one aperture using the sample handling system. Although the container casing may feature several apertures, only one is used as an entry and exit aperture as described herein. Samples may be introduced into and removed from the containerized MR scanner through this one aperture sequentially. Alternatively, an input line and an exit line may both extend though this one aperture to allow for a continuous sample transport.

Although it is possible that the entry aperture and the exit aperture are formed by a single structural aperture, e.g. if removable sidewalls are employed for interconnecting two or more containerized MR systems, it will be beneficial for several applications to separate the apertures from each other, e.g. for allowing for a clear separation of the inbound and outbound stream of samples. Correspondingly, a containerized MR system according to the invention is preferred, wherein the entry aperture and the exit aperture are formed by different apertures. Accordingly, the container casing preferably comprises two or more separate apertures, wherein the containerized MR system is preferably configured to move samples from one of the at least two separate apertures into the MR scanner using the sample handling system and to move samples from the MR scanner to another one of the at least two apertures using the sample handling system. Again, the container casing may feature several apertures, wherein only two apertures are used in this embodiment as separate entry and exit apertures.

To prevent contamination of the interior of the containerized MR system, which may occur e.g. during transport or other phases of inactivity, it is expedient to close the apertures. Hence, a containerized MR system according to the invention is preferred, wherein the entry aperture and/or the exit aperture, preferably the entry aperture and the exit aperture, are reversibly and nondestructively closeable, preferably reversibly and nondestructively sealable, more preferably fluid-tight, and/or wherein the container comprises one or more shutter devices for closing any one of the one or more apertures, i.e. the entry aperture and/or the exit aperture, preferably the entry aperture and the exit aperture.

The afore-mentioned embodiment is particularly beneficial when using the containerized MR system to provide for special working conditions. For example, the containerized MR system may be configured to function as a clean room (e.g. according to ISO 14644 standards) and/or biosafety room. Especially for such cases, a containerized MR system according to the invention is preferred, wherein the containerized MR system comprises one or more airlocks for limiting the exchange of matter between the inside of the container and the outside of the container. Especially preferred is a containerized MR system according to the invention, wherein the one or more airlocks are locking the entry aperture and/or the exit aperture, preferably the entry aperture and the exit aperture.

The skilled person understands that the container can comprise further openings. Exemplary is a containerized MR system according to the invention, wherein the container casing comprises a door, preferably in a sidewall, for allowing entry of humans into the container. This is particularly useful to allow for a more convenient maintenance of the containerized MR system or to enable more complex process steps inside the containerized MR system that require a human operator. From a practical perspective a containerized MR system according to the invention is preferred, wherein the containerized MR system comprises a MR scanner area comprising the MR scanner, wherein the MR scanner area is access restricted within the container, and wherein another area within the container is not access restricted. Such an access restricted area helps to avoid unnecessary interaction between the MR scanner and personal that might enter the container, thereby reducing the risk of damages to the MR scanner or human exposure to strong magnetic fields.

A particular aspect of the invention is directed at facilitating the combination of several containerized MR systems to form a larger containerized MR assembly. In particular for embodiments that do not feature replaceable container sidewalls it is expedient to include additional apertures that allow for transferring samples between two interconnected containerized MR systems. Such additional apertures of one containerized MR system can be connected to the entry aperture and the exit aperture of another containerized MR system to build a pathway through both containerized MR systems. Accordingly, the containerized MR system may preferably be configured to be (structurally and/or functionally) interconnected with another containerized MR system, preferably to allow for the transfer (preferably direct transfer) of samples between the interconnected (preferably adjacent) containerized MR systems.

Accordingly, in another preferred embodiment, the container casing comprises at least four separate apertures. In this embodiment, the containerized MR system is preferably configured to move samples from a first one of the at least four separate apertures to a second one of the at least four separate apertures or into the MR scanner using the sample handling system, and to move samples from a third one of the at least four separate apertures or from the MR scanner to a fourth one of the at least four separate apertures using the sample handling system.

For example, the container casing may comprise an additional entry aperture for introducing samples into the container and an additional exit aperture for moving samples out of the container, wherein the additional entry aperture and the additional exit aperture are separate from the entry aperture and the exit aperture and preferably separate from each other. Preferred embodiments of the additional entry aperture and the additional exit aperture correspond to preferred embodiments of the entry aperture and the exit aperture, respectively, e.g. with respect to the shutters and the sealability, wherein the additional entry aperture and the additional exit aperture are preferably structural identical to the entry aperture and the exit aperture, respectively.

The functional centrepiece of the containerized MR system is the imaging (e.g. MR) scanner, wherein each containerized MR system can also comprise two or more imaging scanners employing different or the same imaging techniques, in which case the layout and configuration of the sample handling system is adapted accordingly. The general structure and function of MR scanner(s) and the concepts of MR and MRI measurements itself, including typical MRI experiments, pulse sequences and techniques, are well known to the skilled person. As indicated above, MR scanners that can be adopted to be included in the containerized MR systems of the present invention are commercially available. While the use of less sophisticated MR techniques can be sufficient for some applications, e.g. in the analysis of fluids that lack any permanent organized molecular structure, the use of MR imaging was found to be particularly powerful for a broad range of industrial applications. Thus, a containerized MR system according to the invention is preferred for the majority of applications, wherein the MR scanner is an MRI scanner, and/or wherein the MR scanner is designed to analyse the samples using magnetic resonance imaging techniques.

With respect to the MR scanner that is used in the containerized MR system the controlled environment in the container beneficially allows for employing a broad variety of different magnetic field strengths, so that the containerized MR systems can be specifically tailored to each specific use case. In this regard, it is an advantage of the containerized MR systems of the present invention that even strong magnetic fields can be used that typically allow for excellent measurement results and shorter experimental times. Generally, a containerized MR system according to the invention is preferred, wherein the MR scanner comprises a magnet, preferably an electromagnet, more preferably a superconducting magnet, that generates a static magnetic field. Preferably, the magnetic field preferably has a suitable magnetic field strength depending on the implementation. For example, the magnetic field may be as low as 0.02 Tesla or even as low as 50 mT, allowing for ultra-low field analysis, or the magnetic field may have a strength of up to 14 Tesla. Preferably, the magnetic field strength is in the range of 0.02 to 14 Tesla, more preferably in the range of 0.1 to 9 Tesla, more preferred in the range of 0.5 to 5 Tesla. The respective magnetic field strengths have proven to be a very efficient compromise between the price of the hardware, the respective maintenance costs and the workplace safety on the one hand and the general quality of the MR data, e.g. with respect to the achievable signal-to-noise ratios, on the other hand.

In the context of the present invention, the MR scanner is used to analyse the samples that are introduced into the container and subsequently fed to the MR scanner. In order to facilitate a high-throughput analysis, besides from operating the scanner with fast sequential measurements of samples, it can also be envisioned to configure the MR scanner to be able to conduct simultaneous measurements. For this a containerized MR system according to the invention is preferred, wherein the MR scanner is configured to allow for the simultaneous measurement of 2 or more, preferably 4 or more, more preferably 8 or more industrial samples.

Another important part of the containerized MR systems of the present invention is the sample handling system that is used for handling the samples, for example to move or transport the samples within the container and which may also contribute to introducing the samples into the container or moving samples out of the container out as described below. Due to this functionality that needs to be provided by the sample handling system, it is least partially located inside the container. For realizing an especially modular MR system with a favourable movability, a containerized MR system according to the invention is preferred, wherein the sample handling system is located predominantly, preferably completely, inside the container.

The sample handling system may be configured to automatically handle the samples. For example, once an analysis routine is started, the sample handling system may, automatically and without further input or control from an operator, move the samples to and from the MR scanner as described herein. Accordingly, the containerized MR system may comprise a control unit configured for controlling the sample handling system to automatically handle the samples.

Preferably, the sample handling system is configured for at least partially, preferably predominantly, more preferably entirely automated transporting of the samples within the container. This may apply to most of the embodiments described herein, as will be understood by the skilled person.

The term "sample handling system" emphasizes that the sample handling system is not necessarily consisting of only one unit but may comprise several elements that interact with each other to enable the desired functionality. Thus, a containerized MR system according to the invention is especially preferred, wherein the sample handling system comprises two or more, preferably three or more sample handling units for handling samples. Preferred is a containerized MR system according to the invention, wherein the sample handling system comprises one or more conveyor systems including, for example, belt conveyors, chain conveyors, pneumatic conveyors, flexible conveyors, or any other suitable conveyor for handling the samples to be analyzed. In addition, the sample handling system may comprise one or more automated robots, e.g. having a robotic arm which may be configured for a rotational motion and/or translational displacement of a sample to be analyzed. The sample handling system may be configured for moving, sorting, selecting, discharging, disposing, and/or manipulating samples. Particularly preferred is a containerized MR system according to the invention, wherein the sample handling system comprises at least a first transport unit for transporting samples that are introduced into the container through the entry aperture into the MR scanner, and a second transport unit for transporting samples that were analysed with the MR scanner out of the MR scanner, preferably towards the exit aperture. In an example, the sample handling system may comprise a conveyor extending from the entry aperture through the MR scanner to the exit aperture, and configured to move samples continuously or intermittently from the entry aperture via the MR scanner to the exit aperture.

Further, the sample handling system may comprise one or more sample sorting mechanisms which allows for sorting the samples, preferably depending at least in part on the outcome of the MR analysis. The sample sorting mechanism may be provided downstream of the MR scanner. For example, the sorted samples may be moved to different (exit) apertures, or may be provided on individual transport lines at the same (exit) aperture. In this manner, an input stream of (unsorted) samples may be provided by a facility to the containerized MR system, and an output stream of sorted samples (e.g. on two separate lines) may be provided back by the containerized MR system to the facility.

Further, the sample handling system may comprise one or more sample selector mechanisms configured to select samples upstream of the MR scanner, wherein the containerized imaging system is configured such that (preferably only) selected samples are analyzed using the imaging scanner (or likewise configured such that selected samples are not analyzed using the imaging scanner). Accordingly, selected samples may be moved into the MR scanner, while other samples may be handled differently. For example, the samples not selected for MR analysis may be bypassed by the MR scanner and moved to the exit aperture, and/or moved to another containerized MR system of a containerized MR assembly. The sample selection may be based on various criteria, including sample characteristics (which may have been determined previously in the external facility, the containerized MR system, or elsewhere), status of the MR scanner (and/or of the MR scanners of other containerized MR systems of a containerized MR assembly), workload of the MR scanner(s), etc.

The parts of the containerized MR system according to the invention are functionally connected with each other so that samples that are introduced into the container through the entry aperture can be transported into the MR scanner using the sample handling system, analysed with the MR scanner and subsequently transported away from the MR scanner using the sample handling system.

The above definition takes into account that it is possible that the introduction of samples into the container and/or the removal of analysed samples from the container can potentially be conducted with external means for handling samples, that could e.g. extend into the container, so that samples are handed over to the internal sample handling system by such external means and/or received from the internal sample handling system by such external means inside the container. However, it is preferred that the sample handling system is also configured for bringing the samples into and/or out of the container. Thus, a containerized MR system according to the invention is preferred, wherein the containerized MR system is configured so that samples can be introduced into the container through the entry aperture to the MR scanner using the sample handling system, and/or wherein the containerized MR system is designed so that samples that were analysed with the MR scanner can be transported away from the MR scanner towards the exit aperture, preferably through the exit aperture, using the sample handling system. Looking at potential structural features for enabling this, a containerized MR system according to the invention is preferred, wherein the sample handling system extends through the entry aperture, so that the containerized MR system is configured so that samples can be introduced into the container through the entry aperture to the MR scanner using the sample handling system, and/or wherein the sample handling system extends through the exit aperture, so that the containerized MR system is configured so that samples that were analysed with the MR scanner can be moved out of the container through the exit aperture using the sample handling system.

A particularly preferred embodiment is obtained when the sample handling system is designed with movable parts in order to allow for a convenient connection of the sample handling system to a facility or to another containerized MR system. For example, a movable or extendable conveyor, e.g. in a telescope design, can be located entirely inside the container during transport until the containerized MR system shall be installed at a facility. For the installation the adaptable conveyor may be rearranged to reach through the entry aperture and/or exit aperture in order to receive samples from outside the container. In view of this, a containerized MR system according to the invention is preferred, wherein the sample handling system comprises modular and/or movable parts and is reversibly and nondestructively adaptable to different layouts, for example by rearranging and/or extending movable conveyors, and/or wherein the containerized MR system is designed so that the layout of the sample handling system can reversibly and nondestructively be changed, preferably to connect the containerized MR system to one or more other sample handling systems of other containerized MRs system and/or to a transport assembly of an external facility.

Particularly preferred is a containerized MR system according to the invention, wherein the sample handling system is reversibly and nondestructively adaptable so that the sample handling system can extend through the entry aperture, so that the containerized MR system is configured so that samples can be transported into the container through the entry aperture to the MR scanner using the sample handling system, and/or wherein the sample handling system is reversibly and nondestructively adaptable so that the sample handling system can extend through the exit aperture, so that the containerized MR system is configured so that samples that were analysed with the MR scanner can be transported out of the container through the exit aperture.

During operation of the containerized MR systems of the present invention, it is desirable to ensure a reliable and controlled hand-over of samples between the containerized MR system and further containerized MR systems and/or a facility that is augmented with the one or more containerized MR systems. For this purpose, a containerized MR system according to the invention is preferred, wherein the sample handling system comprises one or more, preferably two or more, sample transfer mechanisms for transferring samples between the containerized MR system and another containerized MR system or an external facility. For example, the sample transfer mechanism may allow for samples being moved from the sample handling system to the other sample handling system of the other containerized MR system, preferably through the additional entry aperture and/or the additional exit aperture, more preferably through the additional entry aperture and the additional exit aperture.

In another example, the sample transfer system may additionally or alternatively allow for connecting the sample handling system to a transport assembly of the external facility, so that samples can be transferred between the transport assembly and the sample handling system, preferably through the entry aperture and/or the exit aperture, more preferably through the entry aperture and the exit aperture.

The skilled person understands that the containerized MR system may also comprise further elements such as means for operating at least parts of the containerized MR system, notably the sample handling system and the MR scanner. Accordingly, in a particularly preferred embodiment, the containerized MR system further comprises an electronic control unit for controlling at least parts of the containerized MR system, preferably at least both the sample handling system and the MR scanner.

While it is in principle possible to have the controls outside the container, it is in agreement with the general concept of trying to provide a standalone containerized MR system, to include at least major parts of the controls required for operating the containerized MR system into the container as well. Thus, preferred is a containerized MR system according to the invention, wherein the electronic control unit is at least partially, preferably mostly, more preferably entirely, located inside the container.

A very preferred embodiment is obtained when the operation of the containerized MR system and its control unit are remotely operated, e.g. by an external server, e.g. a central process control of a facility, or from a cloud-based computer program. Thus, a containerized MR system is preferred wherein the electronic control unit can be connected or is connected to an external electronic control system, preferably through wireless data transmission.

As mentioned above, it is expedient that the electronic control unit controls at least the MR scanner and/or the sample handling system. Therefore, a containerized MR system according to the invention is preferred, wherein the electronic control unit comprises an electronic MR control unit for controlling the MR scanner, wherein the electronic MR control unit preferably is located inside the container, and/or an electronic sample handling control unit for controlling the sample handling system, wherein the sample handling control unit preferably is located inside the container.

It can be considered an advantage of the present invention that the confined interior of the container allows to efficiently shield the working environment from external influences, thereby allowing for very stable measurement conditions and thus reliable results. To further expand on this advantage it is suggested that a condition control system for controlling the conditions inside the container is installed in order to allow for efficient control of measurement conditions. Such a condition control system can beneficially be used to maintain specialized working conditions inside the container, e.g. with respect to biosafety. Correspondingly, a containerized MR system according to the invention is preferred, wherein the containerized MR system preferably further comprises a condition control system for controlling the conditions inside the container, comprising one or more, preferably two or more, more preferably three or more, devices selected from the group consisting of temperature control devices, pressure control devices, filtration devices for filtering the atmosphere inside the container and protection gas systems for establishing a protection gas atmosphere inside the container.

An important advantage of the MR based analysis is that the obtained results can not only be used to document the quality of the samples under study but can also be used to sort the samples according to predefined properties, e.g. to remove samples that do not meet a predefined (quality) criterion from the product stream. Therefore, the sample handling system may comprise a sample sorting mechanism for sorting the samples that were analysed with the MR scanner based on the result of the analysis, wherein the sample handling system is preferably designed to move the samples that were analysed with the MR scanner away from the MR scanner into different directions depending on the sorting.

An important advantage of the present invention is that the containerized MR system can be interconnected with one or more other containerized MR systems to form a larger assembly. This beneficially allows to efficiently scale the MR capabilities offered by the containerized solution to the actual demand. In the framework of the present invention the resulting assembly is referred to as "modular containerized MR assembly".

Therefore, the invention also relates to a modular containerized imaging (preferably MR) assembly for analysing samples, comprising two or more containerized imaging (preferably MR) systems according to the invention and/or that is obtainable by connecting two or more containerized imaging (preferably MR) systems according to the invention with each other.

This definition emphasizes that the containerized MR systems of the present invention in the modular containerized MR assembly can in principle be operated independently of each other or be interconnected so as to allow for sample transport through two or more of the containers. Generally preferred is a modular containerized MR assembly according to the invention, wherein the containerized MR assembly comprises three or more, preferably four or more, more preferably five or more containerized MR systems. Exemplary is a modular containerized MR assembly according to the invention, wherein the containers of the containerized MR systems are in contact with each other, wherein the container of the containerized MR systems are preferably fixed together with one or more fixing elements. The containerized MR systems of the MR assembly may be interconnected such that they provide for a sequential or parallel analysis of samples. For example, all samples may be analysed in the same manner within different containerized MR systems of the MR assembly (scalability). In another example, samples may be analysed in a first containerized MR system and depending on the analysis outcome analysed in a second containerized MR system of the MR assembly. It will be appreciated that one or more other containers (e.g. providing for buffering, storing, sample preparation, etc.) may be installed between two adjacent containerized MR systems.

While there are clear benefits to using several containerized MR systems that operate mostly independent from each other, there will oftentimes be structural limits to how many containerized MR systems can be directly connected to a facility. Therefore, it is especially preferred to connect two or more containerized MR systems with each other in order to generate a larger, interconnected containerized MR assembly that provides the capability of several containerized MR systems but can be fed from a facility through just a few or even just one entry aperture. Thus, a modular containerized MR assembly according to the invention is preferred, wherein the modular containerized MR assembly is obtainable by connecting two or more containerized MR systems according to invention with each other.

This connection can e.g. be obtained by placing the containers in direct vicinity with each other. However, especially preferred assemblies can be obtained by connecting the interior of the containers by removing removable wall elements of the container as disclosed above. Especially in this case, it is preferred to use a connection interface between the containers in order to ensure that the expanded interior is still sufficiently shielded against the exterior. In view of this, a modular containerized MR assembly according to the invention is preferred, wherein one or more container sidewalls of the container are removed on at least some of the containerized MR systems to connect the interior of two or more containerized MR systems. Especially preferred is a modular containerized MR assembly according to the invention, wherein the modular containerized MR assembly is obtainable by connecting two or more containerized MR systems using a connection interface between at least some of the containerized MR systems.

In order to obtain the best functionality, it is preferred to connect the sample handling systems of the containerized MR systems with each other, wherein "connected" functionally means that samples can be handed over from one sample handling system to another. Correspondingly, a connection can e.g. be obtained by aligning two conveyors with each other using a sufficiently small gap. Thus, a modular containerized MR assembly according to the invention is preferred, wherein the sample handling system of each containerized MR system is connected with at least one other sample handling system of at least one other containerized MR system, preferably through the first connection mechanism and the second connection mechanism. Especially preferred is a modular containerized MR assembly according to the invention, wherein the conveyor systems of all containerized MR systems are connected with each other, preferably through the first connection mechanism and the second connection mechanism.

By this means, a containerized MR assembly according to the invention is obtained, wherein the containerized MR assembly is configured so that different samples can be moved by means of the connected sample handling systems of the containerized MR systems to different MR scanners. Especially preferred is a modular containerized MR assembly according to the invention, wherein the containerized MR assembly is configured so that samples can be conveyed through two or more, preferably three or more, more preferably all of the containers of the containerized MR systems without being outside one of the containers.

Generally preferred is a modular containerized MR assembly according to the invention, wherein the sample handling system of at least one of the containerized MR systems, preferably at least two of the containerized MR systems, more preferably of all but one of the containerized MR systems, partially extends into at least one of the containers of the other containerized MR systems, preferably through the additional entry aperture and/or the additional exit aperture, more preferably through the additional entry aperture and the additional exit aperture.

While it is possible to operate the containerized MR systems in isolation, e.g. in the vicinity of a facility, and e.g. use them for batch wise analysis of samples that are provided from the facility by other means, e.g. carried over by workers of the facility, it is highly preferred to fully utilize the advantages offered by the containerized MR systems of the present invention by directly linking them to production facilities and thereby incorporating the MR analysis into the production process as directly as possible, resulting in an augmented facility that can rely on sophisticated MR analysis for the analysis of the samples produced by said facility.

In view of this, an augmented facility is disclosed, comprising a working area for producing or processing samples, a transport assembly for transporting samples, and a containerized MR system according to the invention or a modular containerized MR assembly according to the invention, wherein the facility is designed so that samples can be transported from the working area to the sample handling system of the containerized MR system using the transport assembly. Particularly preferred, the containerized MR system is located outside of the facility.

Especially relevant will be embodiments, wherein the augmented facility is an industrial facility, preferably a facility of the manufacturing industry, fishing industry or agricultural industry.

Due to the benefits offered by comprehensive MR analysis capabilities, an augmented facility is preferred, wherein the facility comprises a containerized MR assembly.

Beneficially, the transport assembly of the facility that is used to transport samples inside or within the facility can be extended into the containerized MR system or the sample handling system of the containerized MR system can be extended into the facility in order to allow for the required hand-over of samples. Thus, a facility can be envisioned, wherein the transport assembly partially extends into at least one of the containers of the containerized MR assembly, preferably through the entry aperture and/or the exit aperture, more preferably through the entry aperture and the exit aperture, and/or wherein the sample handling system of at least one containerized MR system partially extends into the working area, preferably through the entry aperture and/or the exit aperture, more preferably through the entry aperture and the exit aperture.

The containerized MR system may be directly linked to the facility, e.g. by connecting the transport assembly of the facility directly to the sample handling system of the containerized MR system. In another example, the containerized MR system may be indirectly linked to the facility, e.g. by providing an intermediate container. For example, the intermediate container may be arranged between the facilities structure and the containerized MR system, such that samples are transferred between the facility and the containerized MR system via the intermediate container. For example, the intermediate container may have suitable openings allowing for transferring the samples through the container. The intermediate container may provide for buffer and/or storing functionality, and/or may be configured to provide for a desired sample preparation prior or after the analysis with the containerized MR system.

Beneficially the electronic control units of the containerized MR system (preferably located within the MR system) can communicate with an electronic control system that can e.g. be the central process control of the facility that is also used for controlling the core manufacturing processes of the facility. Thus, a facility is preferred, wherein the facility comprises an electronic control system for controlling one or more, preferably two or more, of the containerized MR systems. Especially preferred is a facility wherein the electronic control system of the facility is preferably located outside the container, and/or wherein the electronic control system unit preferably comprises a server or a cloud.

In view of the above the skilled person understands that the invention also relates to a method for analysing samples, especially industrial samples, with a containerized imaging (preferably MR) system according to the invention or a modular containerized imaging (preferably MR) assembly according to the invention, comprising the steps of:
a) providing at least one sample at one of the one or more apertures,
b) moving the provided sample from the respective aperture into the scanner using the sample handling system,
c) analysing the sample using the scanner, preferably using magnetic resonance techniques, and
d) moving the analyzed sample from the scanner to one of the one or more apertures using the sample handling system.

The method is a method for analysing samples. Therefore, the method according to the invention does not comprise identification of a medical condition in human beings and preferably of living (born) animals.

As will be appreciated, the method may comprise further steps corresponding to the functionality disclosed herein with regard to the containerized imaging system and/or modular containerized imaging assembly. For example, the method may further comprise one or more of the following steps:
Selecting the at least one sample for the imaging analysis, wherein the provided sample is preferably moved into the MR scanner (only) if the sample is selected for the imaging analysis, preferably using the sample selector mechanism;
Transferring the at least one sample not selected for the imaging analysis to one of the one or more apertures, preferably using the sample handling system;
Sorting the at least one sample based at least in part on the imaging analysis of the samples, preferably using the sample sorting mechanism.

As discussed above, it is beneficial to utilize the transportability of the containerized MR systems to augment an existing facility. Correspondingly, a method according to the invention is preferred, wherein the method further comprises the preparational step:
x) Transporting one or more, preferably two or more, containerized MR systems to a facility, preferably by truck and/or train and/or ship and/or plane, preferably by truck. The one or more containerized MR systems may be placed inside the facility, or more preferred, outside of the facility. The one or more containerized MR system may then be connected to the facility such that samples can be transferred between the facility and at least one of the containerized MR systems as described herein.

In order to profit from the enhanced MR capabilities offered by the containerized MR systems of the present invention, a method according to the invention is preferred, wherein two or more containerized MR systems are assembled to form a containerized MR assembly, and/or wherein one or more containerized MR system is connected to the transport assembly of the facility.

The transportability of the containerized MR system can beneficially also be used to reduce the MR capabilities if they are no longer required. Therefore, a method according to the invention can be envisioned, wherein the method further comprises the concluding step:
y) Disassembling the containerized MR assembly and/or disconnecting the containerized MR system(s) from the facility, e.g. from a transport assembly of the facility.

In one embodiment, magnetic resonance techniques are used for analysing samples thereby providing for a non-invasive analysis. The term "non-invasive" is well-known to the skilled person and may be defined in such a manner that the method is non-destructive and does not require incisions or the insertion of instruments into the sample, or the extraction of content from the sample.

It can be considered an advantage of the method according to the invention that the method is not limited to the specific nature of the magnetic resonance techniques that are used for analysing samples, wherein MRI techniques are generally preferred. In a preferred embodiment machine learning can be used to enhance the MR based analysis, e.g. like it is disclosed in EP 4202427 A1.

In particular, a method according to the invention is preferred, wherein the analysing is conducted by analysing MR data of the samples collected by the MR scanner using an inference module employing a machine learning module,
wherein the inference module comprises a memory storing the machine learning module and a processor for controlling the inference module, wherein the inference module is configured to provide the MR data of the samples collected by the MR scanner as an input to the machine learning module and to analyse the MR data using the machine learning module,
wherein the machine learning module is to identify one or more predetermined feature in samples of a predefined sample type using a training set comprising MR data of different training samples of the predefined sample type comprising the predefined feature.

Exemplary is a method according to the invention, wherein the sample is analysed to identify a predetermined feature in a sample of a predefined sample type, wherein the predetermined feature is selected from the group consisting of structural features in the sample, preferably anatomical features, biological features and impurities, and/or wherein the predefined sample type is selected from the group consisting of polymers, animal products, plants, and products derived from these materials, preferably plastics, organic tissues, meat, fish meat, eggs, fruits, seeds and processed food and drinks, more preferably eggs, seeds, nuts and chocolate products.

### Description of preferred embodiments

Hereinafter, the invention is described in more detail, wherein preferred embodiments of the invention are disclosed with respect to the figures. In the figures, similar features are identified with the same reference signs. The figures show:
- Fig. 1: a schematic visualization of a containerized MR system according to the invention in an preferred embodiment;
- Fig. 2: a schematic visualization of an augmented facility comprising the containerized MR system of Fig. 1;
- Fig. 3: a schematic visualization of a containerized MR system according to the invention in another preferred embodiment;
- Fig. 4: a schematic visualization of an augmented facility comprising a preferred containerized MR assembly according to the invention comprising the containerized MR system of Fig. 3;
- Fig. 5: a schematic visualization of a containerized MR system according to the invention in another preferred embodiment; and
- Fig. 6: a schematic visualization of an augmented facility comprising a preferred containerized MR assembly according to the invention comprising the containerized MR system of Fig. 5.

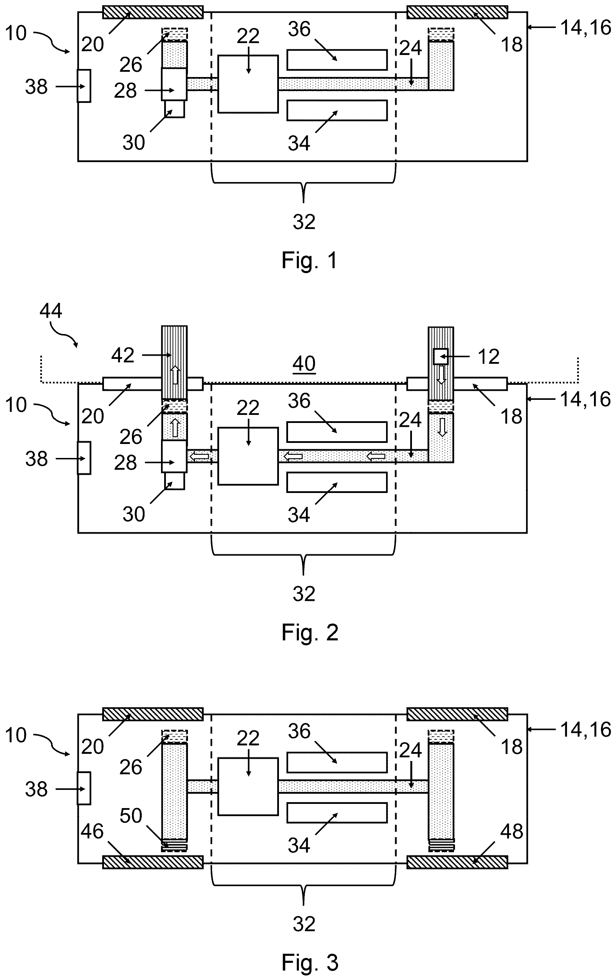

Fig. 1 provides a schematic visualization of a containerized imaging system 10 according to a preferred embodiment of the invention, here realized as a containerized MR system 10. The containerized MR system is configured to impart MR capabilities to external facilities (not shown in fig. 1) to allow for the analysis of samples 12 using non-invasive MR techniques.

The containerized MR system of fig. 1 comprises an imaging scanner 22, realized as an MR scanner 22, that is configured to analyse samples 12 using MR techniques. In the example of fig. 1 the MR scanner is a MRI scanner that comprises a superconducting electro magnet that provides a magnetic field with a magnetic flux density of 9.4 T. Different embodiments may feature different MR scanners or even different imaging scanners.

The MR scanner is arranged inside a container 14 that is based on a standardized intermodal ISO container with a length of 6.058 m (20 foot) with an inner volume of about 33 m³. The container 14 has a container casing 16 which is made of non-magnetic steel. The container 14 is structured to support the (rather heavy) MR scanner. The MR scanner is fixed within the container 14 to the container floor to allow for safe transport and operation.

Due to the layout of the container 14 that comprises the typical carrying elements of ISO containers, the containerized MR system 10 can readily be moved and transported using established logistic chains, e.g. by truck and train. For example, the container 14 comprises corner fixtures which allow for handling and lifting the container 14 in a variety of ways, as will be appreciated by the skilled person.

In order to allow for the analysis of samples 12 with the containerized MR system, the container 14 comprises in one sidewall of the container casing 16 an entry aperture 18 and an exit aperture 20 that are separate from each other and large enough to act as doors that allow for operators to access the inside of the container 14. In the state of the containerized MR system shown in fig. 1, both the entry aperture 18 and the exit aperture 20 are closed using shutter devices that allow for a fluid tight sealing of both the entry aperture 18 and the exit aperture 20 (indicated by a striped shading in fig. 1). Due to this, the containerized MR system of fig. 1 is in a "transport state" that provides for the secure transport of the containerized MR system 10 while protecting the sensitive and valuable equipment located inside the container 14.

The containerized MR system of fig 1 comprises a sample handling system 24 that comprises a set of interconnected conveyors that are indicated with a dotted shading. The sample handling system 24 is configured to move samples (not shown in fig. 1) that are introduced into the container 14, e.g. from an external facility through the entry aperture 18, into the MR scanner, so that the samples can be analysed using the MR scanner. The sample handling system 24 is also configured for moving samples that were analysed using the MR scanner from the MR scanner towards the exit aperture 20. The usage of conveyor belts was identified to allow for a very reliable and robust transport of solid samples 12. However, the conveyors could be replaced or supplemented with other transport units if required, e.g. industry robots.

In the embodiment of fig. 1, both ends of the sample handling system 24 on either side of the MR scanner comprise a connection mechanism 26 to connect the conveyors of the sample handling system 24 to other conveyors as disclosed in more detail below.

The embodiment depicted in fig. 1 comprises a sorting mechanism 28 that is located downstream of the MR scanner. The sorting mechanism 28 is configured for sorting the samples 12 depending on the result of the MR analysis. In the examples of fig. 1, the containerized MR system is configured such that only samples that meet a predefined quality criterion are moved towards the exit aperture 20 e.g. for further processing inside the external facility, while samples that do not meet the predefined quality criterion are sorted out and disposed using a disposal unit 30. In further embodiments, the disposal unit 30 may be located further apart from the sorting mechanism 28, wherein the sample handling mechanism 24 is configured to move the respective samples to said disposal unit 30.

As is visible from fig. 1, the containerized MR system also comprises a condition control system 38 that comprises means for controlling the temperature, humidity and/or pressure inside the container 14.

Although the interior of the containerized MR system is accessible for humans through both the entry aperture 18 and the exit aperture 20, it is desirable to protect the valuable and sensitive MR infrastructure and at the same time limit exposure of operators to strong magnetic fields. In order to reach these goals, the MR scanner is located in an imaging scanner area 32, here in the form of an MR scanner area, that is access restricted using suitable structures, e.g. walls, glass windows or a grating, allowing for the sample handling system to transfer samples to and from the MR scanner. The MR scanner area may be accessed by means of a further door or even airlock (not shown) providing access only to a restricted user group. Inside the MR scanner area the containerized MR system comprises two cabinets 36 that can be used as storage for important tools or other peripheral devices that shall also be kept outside the accessible working area.

In particular, one of the cabinets 36 houses the electronic control unit 34 that functions as a central control for the containerized MR system and is able to control the MR scanner, the sample handling system 24 including the sorting mechanism 28, and the condition control system 38. The electronic control unit 34 is capable of wireless communication and allows for an efficient remote control of the containerized MR system.

Fig. 2 depicts how the containerized imaging system 10 of fig. 1, i.e. the containerized MR system, can be installed at an external facility 40 to provide MR analysis capabilities to said facility and thus arrive at an augmented facility 44. For this, the container 14 of the containerized MR system is transported to the facility 40, e.g. using a truck, and placed in a suitable location, e.g. in the direct vicinity of the facility 40.

After opening the entry aperture 18 and the exit aperture 20, the transport assembly 42 of the facility 40, e.g. a system of conveyor belts used in the facility 40, can be extended to reach into the container 14 of the containerized MR system through the entry aperture 18 and the exit aperture 20, respectively. The transport assembly 42 of the facility 40 can conveniently be connected to the sample handling system 24 of the containerized MR system, e.g. by using the connection mechanisms 26 which is configured for transferring samples 12 between the facility's sample transport assembly 42 and the sample handling system 24 of the containerized MR system, although less sophisticated interconnections between the transport assembly 42 and the sample handling system 24 will be sufficient for several applications. In order to bring the containerized MR system into an operational state it may be connected to the energy supply of the facility 40 and connected to an external control system using (wireless) LAN or other suitable techniques.

In the resulting augmented facility 44, samples 12 can be moved with the transport assembly 42 into the containerized MR system and further into the MR scanner using the sample handling system 24 in order to analyse the samples 12. The path of the samples 12 is indicated in fig. 2 using broad arrows. For example, the facility 40 could be a manufacturing facility that produces non-metal aircraft fuselage components that are analysed in the containerized MR system as a part of the automated quality control. A component may be provided to the containerized MR system, automatically introduced into the MR scanner by means of the sample handling system 24, and automatically analysed with the MR scanner. The component may then be sorted out by the sorting mechanism 28 and disposed in the disposal unit 30 if the recorded MR data indicates that said component does not fulfill a predefined quality criterion. Only components that pass the quality control are moved through the exit aperture 20 out of the container 14 back into the external facility 40 using the sample handling system 24 and the transport assembly 42.

Fig. 3 depicts a schematic visualization of a containerized imaging system 10 according to the invention in another preferred embodiment, again realized in the form of a containerized MR system 10. Compared to the containerized MR system of fig. 1, this embodiment is specifically configured to be connected to further elements of both sides and allow for the assembly of larger containerized imaging assemblies 54, e.g. containerized MR assemblies.

For this, the containerized MR system of fig. 3 comprises an additional entry aperture 46 and an additional exit aperture 48. As fig. 3 again visualizes the "transport state" of the containerized MR system, also the additional entry aperture 46 and the additional exit aperture 48 are sealed by means of shutter devices in fig. 3.

In the embodiment of fig. 3, the conveyor of the sample handling system 24 extends through large parts of the container 14 connecting pairs of entry/exit apertures that are facing each other. In order to facilitate the interconnection of several sample handling systems 24, the ends of the conveyors on both sides of the MR scanner 22 comprise one end that features an extension mechanism 50 that allows for extending the conveyor. The extension mechanism 50 may comprise a telescope part, or an intermediate conveyor part configured to interconnect the sample handling systems 24 of adjacent containers. It will be appreciated that, in addition, a sorting mechanism and possibly a disposal unit may be provided, as described with regard to other embodiments.

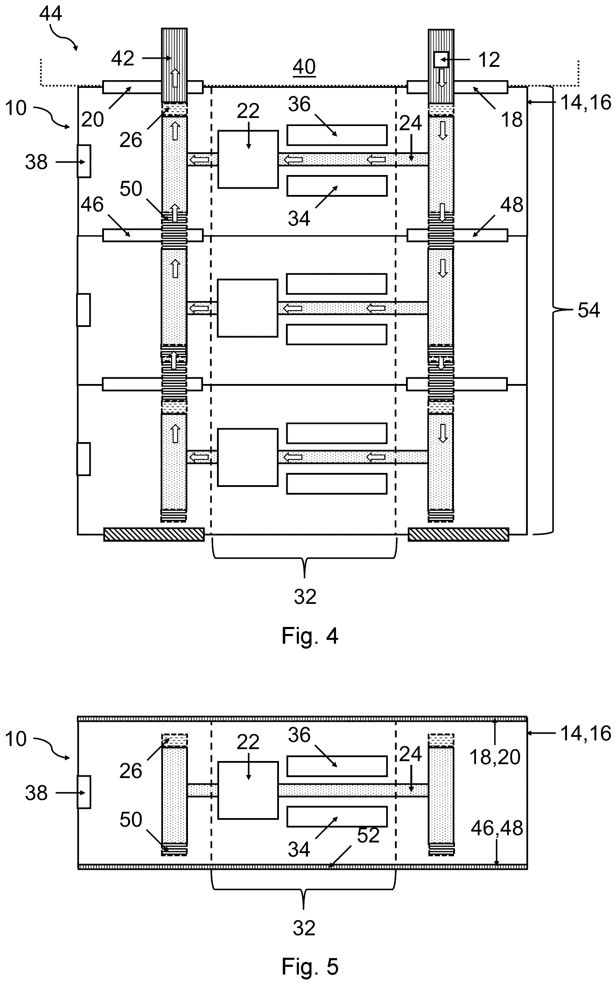

Fig. 4 shows an augmented facility 44 that may be obtained using the containerized imaging system 10 of fig. 3, i.e. the containerized MR systems. The augmented facility 44 of fig. 4 comprises three of the containerized MR systems of fig. 3 that are placed next to each other, wherein all but the additional entry aperture 46 and additional exit aperture 48 of the last containerized MR system (the system at the bottom side of fig. 4) are open. The sample handling systems 24 of the three containerized MR systems are interconnected, wherein the extension mechanisms 50 of two of the containerized MR systems are extending through the corresponding apertures 18 of adjacent containerized MR systems and connect to the respective sample handling systems 24 using the respective connection mechanisms 26. The resulting network of interconnected sample handling systems 24 is connected to the transport assembly 42 of the facility 40 as discussed above with regard to fig. 2. Each container may feature a sample selector mechanism which allows for selecting whether a sample is moved towards the MR scanner 22 of that container, or whether the sample is moved to another container. All sample handling systems 24 of the connected containerized MR systems may be controlled jointly to allow for an efficient and desired operation of the entire containerized imaging assembly 54. Downstream of the MR scanners, the different sample lines may be joined again, as is apparent from fig. 4. Depending on the analysis result, the samples 12 may be sorted and possibly disposed as described elsewhere herein. In certain embodiments, only one containerized MR system of the modular containerized MR assembly, preferably the first one, comprises a respective sample sorting mechanism to sort the samples 12 taking into account the analysis results obtained with MR scanners of other containerized MR systems of the modular containerized MR assembly. In other embodiments, one or more additional containers 14 may be provided, which may also be provided between two adjacent containerized MR systems. The one or more additional container 14 may provide for buffering, storing, sample preparation, etc., not necessarily (but possibly also) providing for sample analysis functionality.

Due to the powerful modular containerized imaging assembly 54, i.e. containerized MR assembly 54, the augmented facility 44 is capable of operating three MR scanners 22 in parallel for high-throughput analysis of samples 12. For example, the augmented facility 44 could be a hatchery, wherein the samples 12 are eggs that shall be analysed for sex or fertility. For this, the modular containerized MR assembly can e.g. be used to employ powerful MR techniques that are enhanced using machine learning as e.g. disclosed in EP 4202427 A1. The modular nature of the containerized MR assembly beneficially allows for fast and easy expansion of the MR capabilities if required. Furthermore, as the containerized MR system can readily be fitted to different types of facilities 40 and can be disassembled within a few hours, it is also possible to use the containerized MR system only temporarily at one facility 40, e.g. for handling seasonal spikes in the production capacity, while employing them at different facilities when the need for MR analysis is reduced at the first facility 40.

In an alternative scenario, the three MR scanners may be operated differently (e.g. scanning with different levels of detail). The samples may be assigned and moved to different MR scanners based on predefined conditions, which may be based on prior testing results (e.g. in the external facility 40, or in an additional container which may be provided between the facility and the first containerized MR system).

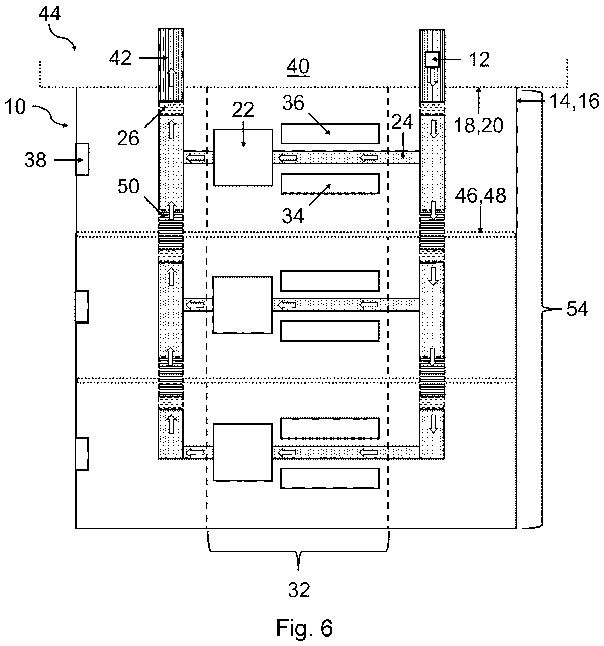

Fig. 5 and 6 are similar to fig. 3 and 4 in that they depict a schematic visualization of a containerized imaging system 10 realized in the form of a containerized MR system 10, and an augmented facility 44 comprising such a containerized MR systems, according to further embodiments of the invention. Compared to the embodiment of fig. 3 and 4, the containerized MR system of fig. 5 and 6 comprises removable container sidewalls 52 that can (partially or fully) be - reversibly and non-destructively - removed to provide for the apertures. Thus, in the embodiment of fig. 5 and 6, the entry aperture 18 and the exit aperture 20 are formed by the same aperture, namely the open side of the container 14 after removal of the removable container sidewall 52. In other words, the removable container sidewall 52 may function as a shutter device for closing the entry aperture 18 and the exit aperture 20. As the containerized MR system of fig. 5 comprises two removable container sidewalls 52, the same arguments apply for the additional entry aperture 46 and the additional exit aperture 48.

Instead of just opening smaller apertures in the sidewall, the assembly of the containerized MR assembly may be obtained by removing at least some of the removable container sidewalls 52 before connecting the sample handling systems 24 and transport assemblies 42 in the expanded interior created in this manner. Fig. 6 depicts that the last containerized MR system in the line can e.g. also be formed by a specially designed containerized MR system that only comprises one removable container sidewall 52 and is designed to form the end of a containerized MR assembly 54. In order to allow for a reliable connection between the containerized MR systems, a connection interface may be provided, e.g. in the form of a double connecting frame that can be fitted to the containers 14 on both sides.

Especially when employing a connection interface, the resulting containerized MR assembly can be operated under specialized working conditions, e.g. as clean room or compliant with biosafety regulations.

### Reference Signs

- 10: containerized imaging system
- 12: sample
- 14: container
- 16: container casing
- 18: entry aperture
- 20: exit aperture
- 22: imaging scanner
- 24: sample handling system
- 26: connection mechanism
- 28: sorting mechanism
- 30: disposal unit
- 32: imaging scanner area
- 34: electronic control unit
- 36: cabinet
- 38: condition control system
- 40: external facility
- 42: transport assembly
- 44: augmented facility
- 46: additional entry aperture
- 48: additional exit aperture
- 50: extension mechanism
- 52: removable container sidewall
- 54: containerized imaging assembly

## Claims

1. Containerized imaging system (10), preferably containerized MR system, for the analysis of samples (12), comprising:
i) a container (14) with a container casing (16),
wherein the container casing (16) comprises one or more apertures for introducing samples (12) into the container (14) and for removing samples (12) from the container (14),
ii) an imaging scanner (22), preferably an MR scanner, for the analysis of samples (12), wherein the imaging scanner (22) is located inside the container (14), and
iii) a sample handling system (24) for handling samples (12), wherein the sample handling system (24) is at least partially located inside the container (14),
wherein the containerized imaging system (10) is configured to move samples (12) from one of the one or more apertures into the imaging scanner (22) using the sample handling system (24),
wherein the containerized imaging system (10) is configured to analyse samples (12) using the imaging scanner (22), and
wherein the containerized imaging system (10) is configured to move samples (12) from the imaging scanner (22) to one of the one or more apertures using the sample handling system (24).

2. Containerized imaging system (10) according to claim 1, wherein the imaging scanner (22) is an MR scanner and wherein the samples (12) are industrial samples.

3. Containerized imaging system (10) according to claim 1 or 2, wherein the container casing (16) encloses a volume of at least 4 m³, preferably of at least 8 m³, more preferably of at least 12 m³, more preferably of at least 16 m³, more preferably of at least 33 m³, more preferably of at least 67 m³.

4. Containerized imaging system (10) according to any one of claims 1 to 3, wherein the container is based on a standardized shipping container or on a structurally reinforced shipping container.

5. Containerized imaging system (10) according to any one of claims 1 to 4, wherein the container casing (16) has one or more container sidewalls being reversibly and non-destructively removably connected to a base structure of the container casing (16).

6. Containerized imaging system (10) according to any one of claims 1 to 5, wherein the container casing (16) comprises one aperture for introducing samples (12) into the container (14) and for removing samples (12) from the container (14), wherein the containerized imaging system (10) is configured to move samples from the one aperture into the imaging scanner (22) using the sample handling system (24) and to move samples from the imaging scanner (22) to the one aperture using the sample handling system (24).

7. Containerized imaging system (10) according to any one of claims 1 to 5, wherein the container casing (16) comprises at least two separate apertures, wherein the containerized imaging system (10) is configured to move samples (12) from one of the at least two separate apertures into the imaging scanner (22) using the sample handling system (24) and to move samples (12) from the imaging scanner (22) to another one of the at least two apertures using the sample handling system (24).

8. Containerized imaging system (10) according to any one of claim 1 to 5 or 7, wherein the container casing (16) comprises at least four separate apertures, wherein the containerized imaging system (10) is further configured to move samples (12) from a first one of the at least four separate apertures to a second one of the at least four separate apertures or into the imaging scanner (22) using the sample handling system (24), and wherein the containerized imaging system (10) is further configured to move samples (12) from a third one of the at least four separate apertures or from the imaging scanner (22) to a fourth one of the at least four separate apertures using the sample handling system (24).

9. Containerized imaging system (10) according to any one of claims 1 to 8, wherein the container (14) comprises one or more shutter devices for closing the one or more apertures.

10. Containerized imaging system (10) according to any one of claims 1 to 9, wherein the sample handling system (24) comprises a sample selector mechanism configured to select samples (12) upstream of the imaging scanner (22), wherein the containerized imaging system (10) is configured to select samples (12) to be analyzed using the imaging scanner (24).

11. Containerized imaging system (10) according to any one of claims 1 to 10, wherein the sample handling system (24) comprises one or more, preferably two or more, sample transfer mechanisms (26) for transferring samples (12) between the containerized imaging system (10) and another containerized imaging system (10) or an external facility (40).

12. Containerized imaging system (10) according to any one of claims 1 to 11, wherein the containerized imaging system (10) comprises:
iv) a condition control system (38) for controlling the conditions inside the container (14), comprising one or more devices selected from the group consisting of temperature control devices, pressure control devices, filtration devices for filtering the atmosphere inside the container (14) and protection gas systems for establishing a protection gas atmosphere inside the container (14).

13. Containerized imaging system (10) according to any one of claims 1 to 12, wherein the sample handling system (24) comprises a sample sorting mechanism (28) for sorting the samples (12) based at least in part on the imaging analysis of the samples (12).

14. Modular containerized imaging assembly (54) for analysing samples (12), comprising two or more containerized imaging systems (10) according to any one of claims 1 to 13.

15. Method for analysing samples (12) with a containerized imaging system (10) according to any one of claims 1 to 13 or with a containerized imaging system (10) of a modular containerized imaging assembly (54) according to claim 14, the method comprising the steps of:
a) Providing at least one sample (12) at one of the one or more apertures,
b) moving the provided sample (12) from the respective aperture into the imaging scanner (22) using the sample handling system (24),
c) analysing the sample (12) using the imaging scanner (22),
d) moving the analyzed sample (12) from the imaging scanner (22) to one of the one or more apertures using the sample handling system (24).
